# EUROPÄISCHE PATENTSCHRIFT

(11) **EP 1 320 896 B1**
(45) Veröffentlichungstag und Bekanntmachung des Hinweises auf die Patenterteilung: **17.12.2008**
(21) Anmeldenummer: 01969730.9
(22) Anmeldetag: 17.09.2001
(51) Int. Cl.: H01L 29/32, H01L 29/861, H01L 29/78

(54) **KÖRPER AUS HALBLEITERMATERIAL MIT REDUZIERTER MITTLERER FREIER WEGLÄNGE**
BODY CONSISTING OF SEMICONDUCTOR MATERIAL, COMPRISING A REDUCED MEAN FREE PATH LENGTH
CORPS EN MATÉRIAU SEMI-CONDUCTEUR À LONGUEUR DE LIBRE PARCOURS MOYEN RÉDUIT

(30) Priorität: 29.09.2000 DE 10048345
(43) Veröffentlichungstag der Anmeldung: 25.06.2003
(73) Patentinhaber: Infineon Technologies AG, 81669 München (DE)
(72) Erfinder: KARTAL, Veli, 81371 München (DE); SCHULZE, Hans-Joachim, 85521 Ottobrunn (DE)
(74) Vertreter: Schmuckermaier, Bernhard
(86) Internationale Anmeldenummer: PCT/EP2001/010751
(87) Internationale Veröffentlichungsnummer: WO 2002/027801

(56) Entgegenhaltungen:
- EP-A- 0 297 325
- EP-A- 0 709 898
- EP-A- 0 797 257
- EP-A- 0 837 506
- EP-A- 0 878 849
- EP-A- 1 014 453
- US-A- 5 250 446

## Beschreibung

Körper aus Halbleitermaterial mit reduzierter mittlerer freier Weglänge

Die Erfindung betrifft einen Körper aus dotiertem Halbleitermaterial zumindest eines Leitungstyps, das eine mittlere freien Weglänge für freie Ladungsträger im Halbleitermaterial und zumindest einen Bereich aufweist, in welchem eine mittlere freie Weglänge für die freien Ladungsträger im Halbleitermaterial vorhanden ist, die relativ zur einen mittleren freien Weglänge des Halbleitermaterials für die freien Ladungsträger reduziert ist.

Ein Körper der genannten Art ist in der nicht vorveröffentlichten älteren deutschen Patentanmeldung 10030381.1 (2000 P 12486) vorgeschlagen .

Bei diesem vorgeschlagenen Körper ist das dotierte Halbleitermaterial unterschiedlich dotiert und weist auf:
- Einen Übergang zwischen einen Leitungstyp und einen zu diesem Leitungstyp entgegengesetzten Leitungstyp,
- für jeden Leitungstyp je eine mittlere freie Weglänge für freie Ladungsträger im Halbleitermaterial, und
- für einen der beiden Leitungstypen einen Bereich, in welchem eine mittlere freie Weglänge für die freien Ladungsträger im Halbleitermaterial vorhanden ist, die relativ zur mittleren freien Weglänge für die freien Ladungsträger des Halbleitermaterials dieses einen Leitungstyps reduziert ist.

Der Bereich reduzierter mittlerer freier Weglänge für die freien Ladungsträger im Halbleitermaterial führt generell zu besseren elektrischen Eigenschaften des Körpers aus Halbleitermaterial. So wird bei dem bereits vorgeschlagenen Körper Durch diesen Bereich eine hohe elektrische Durchbruchfestigkeit erreicht.

Aus der EP 0 878 849 A ist eine Leistungsdiode mit in Form einer Matrix angeordneten, säulenförmigen Zellen bekannt, in denen die Ladungsträgerlebensdauer aufweisen gegenüber dem die säulenförmigen Zellen umgebenden Bereich der Leistungsdiode reduziert ist. Die Verringerung der Ladungsträgerlebensdauer wird durch eine maskierte Elektronenbestrahlung erreicht.

Die EP 0 797 257 A zeigt einen Leistungsthyristor, in dessen n-dotierter Basis durch Implantation schwerer Ionen erzeugte Implantationsgebiete regelmäßig angeordnet sind. Durch die Implantation wird in den Implantationsgebieten die Kristallstruktur des Thyristors geschädigt und die Ladungsträgerlebensdauer gegenüber den unbestrahlten Bereichen der n-dotierten Basis reduziert.

Aufgabe der Erfindung ist es, einen Körper der eingangs genannten Art bereitzustellen, der noch bessere elektrische Eigenschaften aufweist.

Diese Aufgabe wird durch die im Anspruch 1 angegebenen Merkmale gelöst.

Wesentlich bei der Erfindung ist, dass der Bereich reduzierter mittlerer freier Weglänge Abschnitte aufweist, die in zumindest einer bestimmten Richtung aufeinanderfolgen und zwischen denen zumindest ein Gebiet vorhanden ist, in welchem eine relativ zur redusierten mittlenen freien weglänge größere mittlere freie weglänge für die freien Ladungsträger im Halbleitermaterial herrscht.

Demgemäß ist bei dem erfindungsgemäßen Körper der Bereich reduzierter mittlerer freier Weglänge nicht wie bei dem bisher vorgeschlagenen Körper durchgehend, sonder durch zumindest ein Gebiet mit relativ zu dieser Weglänge größerer mittlerer freier Weglänge unterbrochen. Dadurch wird die Erzeugung der Ladungsträger durch Stoßionisation im Bereich reduzierter mittlerer freier Weglänge durch die reduzierte freie Weglänge der Ladungsträger behindert.

In dem oder den Gebieten in dem bzw. denen die relativ zur reduzierten mittleren freien Weglänge größere mittlere freie Weglänge für die freien Ladungsträger im Halbleitermaterial herrscht, wird dies durch die Geometrie jedes Gebiets erreicht. Die Ladungsträger brauchen eine gewisse Weglänge, um auf dieser genügend Energie aufnehmen zu können, um selbst weitere Ladungsträger durch Stoßionisation erzeugen zu können. Wird diese Weglänge klein gehalten, so können diese Ladungsträger nicht genügend Energie aufnehmen.

Beim erfindungsgemäßen Körper ist vorteilhafterweise gewährleistet, dass ein elektrischer Stromfluss nicht ausschließlich in einem Bereich reduzierter mittlerer freier Weglänge stattfindet, sondern dass der Strom auch in wenigstens einem Gebiet fließt, in dem die mittlere freie Weglänge größer als die reduzierte mittlere freie Weglänge ist.

Dadurch kann mit dem erfindungsgemäßen Körper vorteilhafterweise ein Bauelement mit einem Körper aus Halbleitermaterial realisiert werden, in welchem nicht überall, wo eine hohe elektrische Feldstärke herrscht, die freie Weglänge der Ladungsträger reduziert sein muss.

Bei dem erfindungsgemäßen Körper ist dessen elektrische Durchlasseigenschaft gegenüber dem Körper mit dem bisherigen durchgehenden Bereich reduzierter mittlerer freier Weglänge verbessert.

Eine vorteilhafte Ausgestaltung des erfindungsgemäßen Körpers ist so ausgebildet, dass ein Abstand zwischen benachbarten Gebieten mit relativ zur reduzierten mittleren freien Weglänge größerer mittlerer freier Weglänge, die durch einen diesen Abstand bestimmenden Abschnitt des Bereichs reduzierter mittlerer freier Weglänge getrennt sind, derart vom Betrag einer durch Anlegen einer bestimmten elektrischen Spannung an den Körper im Halbleitermaterial erzeugten elektrischen Feldstärke abhängt, dass dieser Abstand an einer Stelle kleineren Betrags kleiner und an einer Stelle größeren Betrags größer ist. Beispielsweise kann dies bedeuten, dass solche Gebiete dort in größerer Dichte angeordnet sind, wo der Betrag der elektrischen Feldstärke kleiner ist, und dort in geringerer Dichte angeordnet sind, wo der Betrag der elektrischen Feldstärke größer ist.

Eine andere vorteilhafte Ausgestaltung des erfindungsgemäßen Körpers ist so ausgebildet, dass ein Abstand zwischen benachbarten Abschnitten des Bereichs reduzierter mittlerer freier Weglänge, die durch ein Gebiet mit einer relativ zur reduzierten mittleren freien Weglänge größeren mittleren freien Weglänge getrennt sind, derart vom Betrag einer durch Anlegen einer bestimmten elektrischen Spannung an den Körper im Halbleitermaterial erzeugt elektrischen Feldstärke abhängt, dass dieser Abstand an einer Stelle kleineren Betrags größer und an einer Stelle größeren Betrags kleiner ist. Beispielsweise kann dies bedeuten, dass solche Abschnitte dort in größerer Dichte angeordnet sind, wo der Betrag der elektrischen Feldstärke größer ist, und dort in geringerer Dichte angeordnet sind, wo der Betrag der elektrischen Feldstärke kleiner ist.

Diese eine und andere Ausführungsform können miteinander kombiniert werden.

Bevorzugter- und vorteilhafterweise ist die relativ größere mittlere freie Weglänge eines Gebiets gleich der einen mittleren freien Weglänge des dotierten Halbleitermaterials des einen Leitungstyps außerhalb des Bereichs der reduzierten mittleren freien Weglänge ist.

Eine besonders bevorzugte und vorteilhafte Ausführungsform des erfindungsgemäßen Körpers ist ähnlich wie der bereits vorgeschlagene Körper so ausgebildet, dass das dotierte Halbleitermaterial unterschiedlich dotiert ist, und
- zumindest einen Übergang zwischen einem Leitungstyp und einem zu diesem Leitungstyp entgegengesetzten Leitungstyp aufweist,
- für jeden Leitungstyp je eine mittlere freie Weglänge für freie Ladungsträger im Halbleitermaterial aufweist und
- für zumindest einen der beiden Leitungstypen einen Bereich aufweist, in welchem eine mittlere freie Weglänge für die freien Ladungsträger im Halbleitermaterial vorhanden ist, die relativ zur mittleren freien Weglänge für die freien Ladungsträger des Halbleitermaterials dieses einen Leitungstyps reduziert ist,
- wobei der Bereich reduzierter mittlerer freier Weglänge zumindest zwei Abschnitte aufweist, die in Richtung senkrecht zu einer Fläche, in der sich der Übergang erstreckt, aufeinanderfolgen, und zwischen denen ein Gebiet vorhanden ist, in welchem eine relativ zur reduzierten mittleren freien Weglänge größere mittlere freie Weglänge für die freien Ladungsträger im Halbleitermaterial herrscht, und/oder
- wobei der Bereich reduzierter mittlerer freier Weglänge zumindest zwei Abschnitte aufweist, die in zumindest einer Richtung parallel zur Fläche, in der sich der Übergang erstreckt, aufeinanderfolgen, und zwischen denen ein Gebiet vorhanden ist, in welchem eine relativ zur reduzierten mittleren freien Weglänge größere mittlere freie Weglänge für die freien Ladungsträger im Halbleitermaterial herrscht.

An den Übergang der vorteilhaften Ausführungsform kann vorteilhafterweise einerseits eine hohe Sperrspannung angelegt werden, andererseits ist die Durchlasseigenschaft des Übergangs verbessert.

Bei einer bevorzugten und vorteilhaften Ausgestaltung der vorteilhaften Ausführungsform hängt ein Abstand zwischen benachbarten Gebieten, die durch einen Abschnitt des Bereichs reduzierter mittlerer freier Weglänge getrennt sind, derart vom Betrag einer durch Anlegen einer bestimmten elektrischen Sperrspannung an den Übergang im Halbleitermaterial erzeugten elektrischen Feldstärke ab, dass dieser Abstand an einer Stelle kleineren Betrags größer und an einer Stelle größeren Betrags kleiner ist.

Mit dem erfindungsgemäßen Körper, insbesondere in seiner vorteilhaften Ausführungsform, kann vorteilhafterweise ein Hochvolt-Bauelement mit einem Körper aus Halbleitermaterial realisiert werden, das einerseits geringe Durchlass- und Schaltverluste, andererseits aber auch ein geringes Bauelementvolumen aufweist. Damit kann sowohl ein Hochvolt-Bauelement mit geringem Volumen als auch ein Hochvolt-IC (HVIC) höchster Integration realisiert werden.

Hochvolt-Bauelemente werden heute im Wesentlichen durch die Wahl einer möglichst geringen Grunddotierung in einer n-dotierten Basis seines Körpers aus Halbleitermaterial realisiert. Dieser Maßnahme sind unter dem Gesichtspunkt einer möglichst geringen Gesamtverlustleistung im Bauelement Grenzen gesetzt, da die Erniedrigung der Grunddotierung i.a. auch eine erhöhte Bauelementdicke bedingt. HVICs werden u.a. entweder in "Junction Isolation"-Technik (JI-Technik) oder in "Dielectric Isolation"-Technik (DI-Technik) realisiert. Bei beiden Techniken ist eine "dicke" Driftzone erforderlich, um die notwendige Sperrspannung aufnehmen zu können.

Mit dem erfindungsgemäßen Körper kann neben beispielsweise einem Thyristor, Transistor, Leistungs-MOSFET-HVIC auch ein elektrischer Widerstand realisiert werden.

Die Erfindung wird in der nachfolgenden Beschreibung anhand der Zeichnungen beispielhaft näher erläutert. Es zeigen:
Figur 1 einen Querschnitt durch eine mit einem Körper gebildete hochsperrende Diode senkrecht zur Fläche eines pn-Übergangs des Körpers und
Figur 2 einen Querschnitt durch ein mit einem Körper gebildetes Hochvolt-MOS-Bauelement senkrecht zur Fläche eines pn-Übergangs des Körpers.
Figur 3 einen Ausschnitt aus einem Bereich reduzierter mittlerer freier Weglänge eines erfindungsgemäßen Körpers mit Gebieten relativ größerer mittlerer freier Weglänge, die unterschiedliche Abstände voneinander aufweisen, und
Figur 4 einen Ausschnitt aus einem Bereich reduzierter mittlerer freier Weglänge eines Körpers mit Abschnitten dieses Bereichs, die unterschiedliche Abstände voneinander aufweisen.

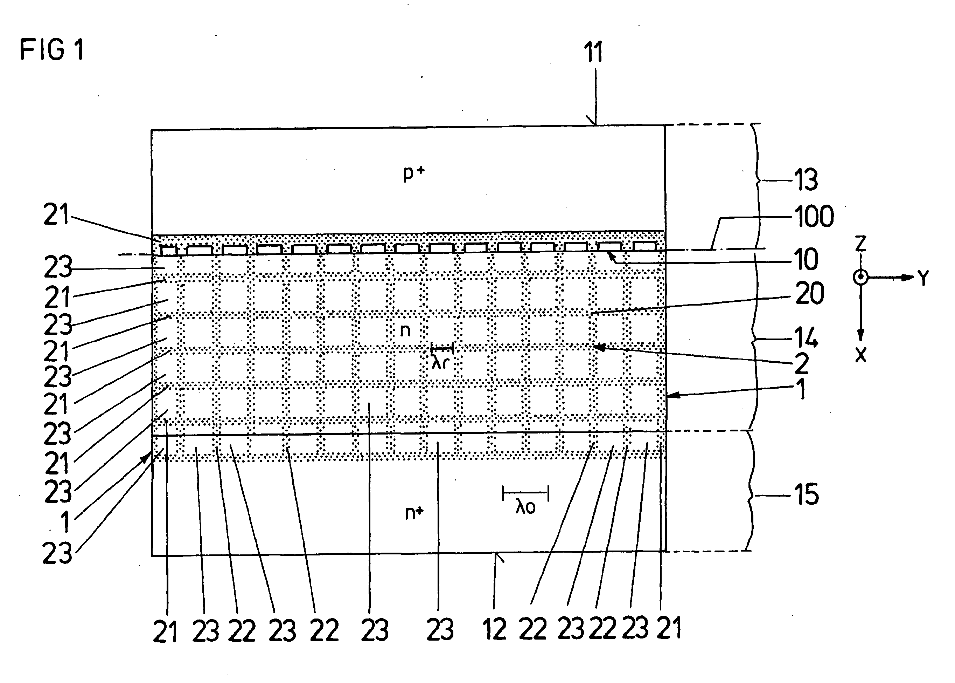

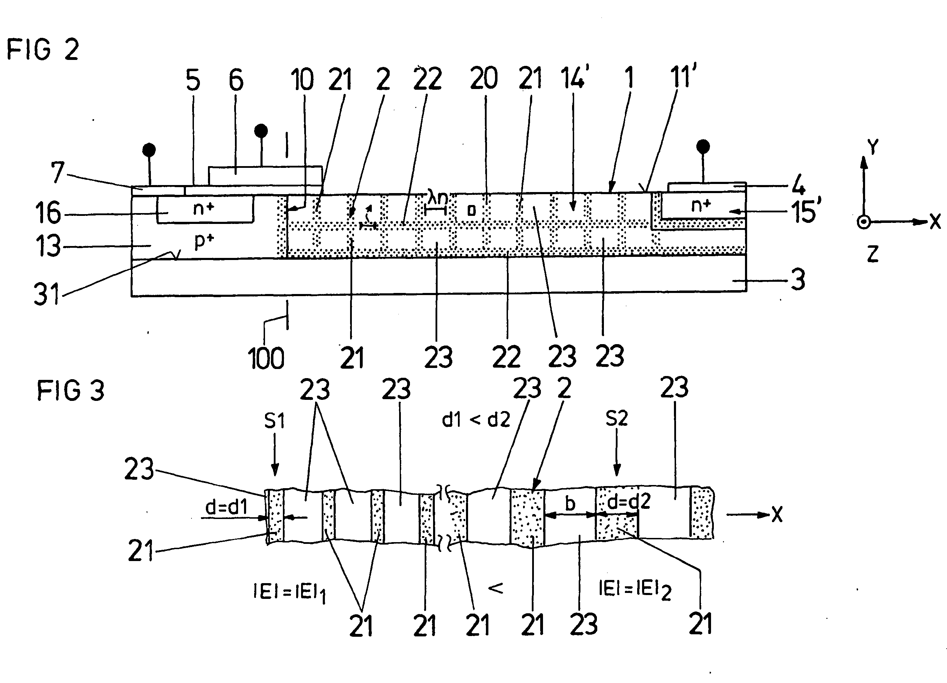

Die Figuren sind schematisch und nicht maßstäblich. In den Figuren 1 und 2 ist der Körper aus dotiertem Halbleitermaterial generell mit 1 und der Bereich reduzierter mittlerer freier Weglänge generell mit 2 bezeichnet.

Der Bereich 2 befindet sich in beiden Fällen beispielsweise im Wesentlichen nur in n-dotiertem Halbleitermaterial des Körpers 1, d.h. in Halbleitermaterial des Leitungstyps n. Im Wesentlichen bedeutet, dass es in vielen Fällen sinnvoll ist, den Bereich 2 auch in Halbleitermaterial des Leitungstyps p des Körpers 1, das eine hohe elektrische Feldstärke aufweist, auszudehnen, beispielsweise so, wie es in den Figuren 1 und 2 angedeutet ist.

In dem n-dotierten Halbleitermaterial, in dem sich der Bereich 2 im Wesentlichen erstreckt, ist eine mittlere freie Weglänge λ0 für freie Ladungsträger gegeben.

In dem gepunktet schattiert gekennzeichneten Teil 20 des Bereichs 2 herrscht eine mittlere freie Weglänge λr für die freien Ladungsträger im n-dotierten Halbleitermaterial, die relativ zur gegebenen mittleren freien Weglänge λ0 dieses Halbleitermaterials reduziert ist.

Der Bereich 2 reduzierter mittlerer freier Weglänge λr weist Abschnitte auf, die in zumindest einer bestimmten Richtung aufeinanderfolgen und zwischen denen zumindest ein Gebiet vorhanden ist, in welchem eine relativ zur reduzierten mittleren freien Weglänge λr größere mittlere freie Weglänge für die freien Ladungsträger im Halbleitermaterial herrscht.

Beispielsweise folgen in den Figuren 1 und 2 in der Richtung x mehrere Abschnitte 21 des Bereichs 2 aufeinander, in denen jeweils die reduzierte mittlere freie Weglänge λr herrscht und zwischen denen Gebiete 23 vorhanden sind, in denen jeweils eine relativ zur reduzierten mittleren freien Weglänge

λr größere mittlere freie Weglänge für die freien Ladungsträger im Halbleitermaterial, beispielsweise die gegebene größere Weglänge λ0, herrscht.

Auch in der zur Richtung x senkrechten Richtung y folgen beispielsweise mit 22 bezeichnete Abschnitte des Bereichs 2 aufeinander, in denen jeweils die reduzierte mittlere freie Weglänge λr herrscht und zwischen denen Gebiete 23 vorhanden sind, in denen jeweils eine relativ zur reduzierten mittleren freien Weglänge λr größere mittlere freie Weglänge für die freien Ladungsträger im Halbleitermaterial, beispielsweise die gegebene größere Weglänge λ0, herrscht.

Analoges kann auch in der zu den Richtungen x und y und zur Zeichenebene der Figuren senkrechten Richtung z gegeben sein.

Insbesondere ist in den Figuren 1 und 2 beispielsweise jedes Gebiet 23 vollständig von Abschnitten 21 und 22 des Bereichs 2 umschlossen und überdies sind speziell die Gebiete 23 in den Richtungen x und y matrixförmig wie in Zeilen und Spalten angeordnet. Jeder Abschnitt 21 erstreckt sich in der Richtung y durch den ganzen Bereich 2, jeder Abschnitt 22 erstreckt sich in der Richtung x durch den ganzen Bereich 2, und die Abschnitte 21 und 22 kreuzen sich und schließen die Gebiete 23 zwischen sich ein.

Beim beispielhaften Körper 1 nach den Figuren 1 und 2 ist das dotierte Halbleitermaterial von zueinander entgegengesetztem Leitungstyp p und n, d.h. p- und n-dotiert, und weist einen pn-Übergang 10 auf, der sich in einer zur Zeichenebene dieser Figuren senkrecht stehenden Fläche 100 erstreckt.

Für jeden Leitungstyp p bzw. n weist das Halbleitermaterial je eine gegebene mittlere freie Weglänge λ0 für freie Ladungsträger im Halbleitermaterial auf.

Der Bereich 2 der reduzierten mittleren freien Weglänge λr erstreckt sich im Wesentlichen nur im n-dotierten Halbleitermaterial und grenzt zumindest an den pn-Übergang 10 des Körpers 1.

Die Richtung x, in der die Abschnitte 21 aufeinanderfolgen und zwischen denen die Gebiete 23 vorhanden sind, steht beispielsweise senkrecht zur Fläche 100, in der sich der pn-Übergang 10 erstreckt.

Außerdem ist die Richtung y, in der die Abschnitte 22 aufeinanderfolgen und zwischen denen die Gebiete 23 vorhanden sind, beispielsweise parallel zur Fläche 100, in der sich der pn-Übergang 10 erstreckt, ausgerichtet.

Ähnliches kann auch für die Richtung z gegeben sein, die ebenfalls parallel zur Fläche 100, in der sich der pn-Übergang 10 erstreckt, ausgerichtet ist.

Der Körper 1 nach Figur 1 ist der einer hochsperrenden Diode. Dieser Körper 1, dessen Halbleitermaterial z.B. aus Silizium besteht, weist beispielsweise einen an einen Oberflächenabschnitt 11 dieses Körpers 1 grenzenden und von einer auf diesem Oberflächenabschnitt 11 angeordneten, nicht dargestellten Anschlusselektrode der Diode kontaktierten p⁺-dotierten Bereich 13, einen auf der vom Oberflächenabschnitt 11 abgekehrten Seite des Bereichs 13 an diesen Bereich 13 grenzenden n-dotierten Bereich 14 und einen auf der vom Oberflächenabschnitt 11 abgekehrten Seite des Bereichs 14 an diesen Bereich 14 grenzenden n⁺-dotierten Bereich 15 auf, der zudem an einen vom Oberflächenabschnitt 11 abgekehrten Oberflächenabschnitt 12 des Körpers 1 grenzt und von einer auf dem Oberflächenabschnitt 12 angeordneten, nicht dargestellten Anschlusselektrode der Diode kontaktiert ist.

Die Grenzfläche zwischen dem p⁺-dotierten Bereich 13 und dem n-dotierten Bereich 14 bildet die Fläche 100, in der sich der pn-Übergang 10 der Diode erstreckt.

Der die Abschnitte 21 und 22 sowie die Gebiete 23 aufweisende Bereich 2 reduzierter mittlerer freier Weglänge erstreckt sich im Wesentlichen nur über den n-dotierten Bereich 14, d.h. er ragt i.a. nur geringfügig in den p⁺-dotierten Bereich 13 und/oder in den n⁺-dotierten Bereich 15 hinein. Bezüglich dieser Erstreckung und die sonstigen Maßgaben des Bereichs 2 siehe das in der älteren deutschen Patentanmeldung 10030381.1 darüber Gesagte, das hier auch gilt.

Der Körper 1 nach Figur 2 ist der eines Hochvolt-MOS-Bauelements. Dieser Körper 1, der z.B. ebenfalls aus Silizium besteht, ist beispielsweise auf der Oberfläche 31 eines Substrats 3 aus elektrisch isolierendem Material, beispielsweise SiO₂, angeordnet. Der pn-Übergang 10 dieses Körpers 1 erstreckt sich in der senkrecht zur Oberfläche 31 des Substrats 3 stehenden Fläche 100 und trennt einen linken p⁺-dotierten Bereich 13' des Körpers 1 von einem rechten n-dotierten Bereich 14' des Körpers 1. Sowohl der p⁺-dotierte Bereich 13'als auch der n-dotierte Bereich 14' grenzen jeweils an einen vom Substrat 3 abgekehrten Oberflächenabschnitt 11' des Körpers 1.

Im n-dotierten Bereich 14' ist in einem Abstand vom pn-Übergang 10 ein n⁺-dotierter Bereich 15' angeordnet, der an den Oberflächenabschnitt 11' des Körpers 1 grenzt und von einer auf dem Oberflächenabschnitt 11' angeordneten Drain-Elektrode 4 des Bauelements kontaktiert ist.

Im p⁺-dotierten Bereich 13' ist in einem Abstand vom pn-Übergang 10 ein n⁺-dotierter Bereich 16 angeordnet, der an den Oberflächenabschnitt 11' des Körpers 1 grenzt.

Über dem pn-Übergang 10 ist auf dem Oberflächenabschnitt 11' des Körpers 1 eine Schicht 5 aus elektrisch isolierendem Material angeordnet, die sich vom n-dotierten Bereich 14' über den p⁺-dotierten Bereich 13' in den n⁺-dotierten Bereich 16 erstreckt und nur einen Teil des Bereichs 13' und des Bereichs 16 abdeckt.

Auf der Schicht 5 aus elektrisch isolierendem Material ist über dem pn-Übergang 10 eine Gate-Elektrode 6 des Bauelements angeordnet, die sich ebenfalls vom n-dotierten Bereich 14' über den p⁺-dotierten Bereich 13' in den n⁺-dotierten Bereich 16 erstreckt.

Der nicht abgedeckte Teil des Bereichs 13' und des Bereichs 16 sind gemeinsam von einer auf dem Oberflächenabschnitt 11' des Körpers 1 angeordneten Source-Elektrode 7 des Bauelements kontaktiert.

Die Grenzfläche zwischen dem p⁺-dotierten Bereich 13 und dem n-dotierten Bereich 14 bildet die Fläche 100, in der sich der pn-Übergang 10 der Diode erstreckt.

Der die Abschnitte 21 und 22 reduzierter mittlerer freier Weglänge λr sowie die Gebiete 23 mit relativ zur reduzierten mittleren freien Weglänge λr größerer mittlerer freier Weglänge aufweisende Bereich 2 reduzierter mittlerer freier Weglänge λr erstreckt sich im Wesentlichen nur über den n-dotierten Bereich 14', d.h. er ragt, i.a. nur geringfügig in den p⁺-dotierten Bereich 13' und/oder in den n⁺-dotierten Bereich 15' hinein. Bezüglich dieser Erstreckung und die sonstigen Maßgaben des Bereichs 2 siehe auch hier das in der älteren deutschen Patentanmeldung 10030381.1 darüber Gesagte, das hier ebenfalls gilt.

Die Figur 3 zeigt einen Ausschnitt aus einem Bereich 2 reduzierter mittlerer freier Weglänge eines erfindungsgemäßen Körpers 1 in der Schnittdarstellung nach den Figuren 1 und 2.

Bei diesem Bereich 2 folgen Abschnitte 21 des Bereichs 2, in denen jeweils die reduzierte mittlere freie Weglänge λr herrscht, in der Richtung x aufeinander, und zwischen diesen Abschnitten 21 sind Gebiete 23 vorhanden, in denen jeweils eine relativ zur reduzierten mittleren freien Weglänge λr größere mittlere freie Weglänge für die freien Ladungsträger im n-dotierten Halbleitermaterial, beispielsweise die gegebene größere Weglänge λ0, herrscht.

In diesem Bereich 2 ist ein Abstand zwischen benachbarten Gebieten 23 mit relativ zur reduzierten mittleren freien Weglänge λr größerer mittlerer freier Weglänge, die durch einen Abschnitt 21 des Bereichs 2 reduzierter mittlerer freier Weglänge λr getrennt sind und welcher Abschnitt 21 diesen Abstand durch seine Ausdehnung d in der Richtung x bestimmt, derart vom Betrag |E| einer durch Anlegen einer bestimmten elektrischen Spannung an den Körper 1 im Halbleitermaterial erzeugten elektrischen Feldstärke E abhängt, dass dieser Abstand d an einer Stelle kleineren Betrags |E| kleiner und an einer Stelle größeren Betrags |E| größer ist.

Beispielsweise herrsche in der Figur 3 an der linken Stelle S1 der Wert |E|₁ und an der rechten Stelle S2 der Wert |E|₂ des Betrags |E| der elektrischen Feldstärke E, wobei |E|₁ kleiner als |E|₂ gelte. Entsprechend hat der Abstand d an linken Stelle S1 einen Wert d1, der kleiner ist, als der Wert d2 des Abstandes d an der rechten Stelle S2.

Beispielsweise kann dies bedeuten, dass solche Gebiete 23 dort in größerer Dichte angeordnet sind, wo der Betrag |E| der elektrischen Feldstärke E kleiner ist, und dort in geringerer Dichte angeordnet sind, wo der Betrag |E| der elektrischen Feldstärke E größer ist.

Die Ausdehnung b jedes Gebiets 23 in der Richtung x kann für mehrere oder alle Gebiete 23 gleich oder unterschiedlich sein.

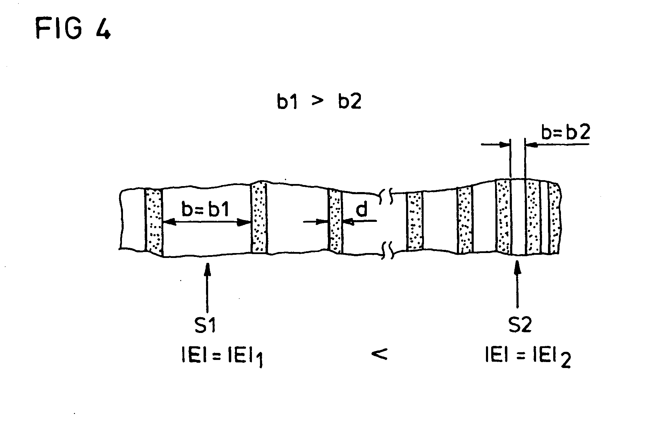

Die Figur 4 zeigt einen Ausschnitt aus einem Bereich 2 reduzierter mittlerer freier Weglänge eines Körpers 1 in der Schnittdarstellung nach den Figuren 1 und 2. Bei diesem Bereich 2 folgen ebenfalls Abschnitte 21 des Bereichs 2, in denen jeweils die reduzierte mittlere freie Weglänge λr herrscht, in der Richtung x aufeinander, und zwischen diesen Abschnitten 21 sind Gebiete 23 vorhanden, in denen jeweils eine relativ zur reduzierten mittleren freien Weglänge λr größere mittlere freie Weglänge für die freien Ladungsträger im n-dotierten Halbleitermaterial, beispielsweise die gegebene größere Weglänge λ0, herrscht.

In der Figur 4 ist ein Abstand zwischen benachbarten Abschnitten 21 des Bereichs 2 reduzierter mittlerer freier Weglänge λr, die durch ein Gebiet 23 mit einer relativ zur reduzierten mittleren freien Weglänge λr größeren mittleren freien Weglänge getrennt sind und welches Gebiet 23 diesen Abstand durch seine Ausdehnung b in der Richtung x bestimmt, derart vom Betrag |E| einer durch Anlegen einer bestimmten elektrischen Spannung an den Körper im Halbleitermaterial erzeugt elektrischen Feldstärke E abhängt, dass dieser Abstand b an einer Stelle kleineren Betrags |E| größer und an einer Stelle größeren Betrags |E| kleiner ist.

Beispielsweise herrsche in der Figur 4 an der linken Stelle S1 der Wert |E|₁ und an der rechten Stelle S2 der Wert |E|₂ des Betrags |E| der elektrischen Feldstärke E, wobei wiederum |E|₁ kleiner als |E|₁ gelte. Entsprechend hat der Abstand b an linken Stelle S1 einen Wert b1, der größer ist, als der Wert b2 des Abstandes b an der rechten Stelle S2.

Beispielsweise kann dies bedeuten, dass solche Abschnitte 21 dort in größerer Dichte angeordnet sind, wo der Betrag |E| der elektrischen Feldstärke E größer ist, und dort in geringerer Dichte angeordnet sind, wo der Betrag |E| der elektrischen Feldstärke E kleiner ist.

Die Ausdehnung d jedes Abschnitts 21 in der Richtung x kann für mehrere oder alle Abschnitte 21 gleich oder unterschiedlich sein.

## Patentansprüche

1. Körper (1) aus dotiertem Halbleitermaterial zumindest eines Leitungstyps (n; p), das eine mittlere freie Weglänge (λ0) für freie Ladungsträger im Halbleitermaterial und zumindest einen Bereich (2) aufweist, in welchem eine mittlere freie Weglänge (λr) für die freien Ladungsträger im Halbleitermaterial vorhanden ist, die relativ zur einen mittleren freien Weglänge (λ0) des Halbleitermaterials für die freien Ladungsträger reduziert ist,
- wobei der Bereich (2) reduzierter mittlerer freier Weglänge (λr) Abschnitte (21, 22) aufweist, die in zumindest einer bestimmten Richtung (x, y, z) aufeinanderfolgen und zwischen denen zumindest ein Gebiet (23) vorhanden ist, in welchem eine relativ zur reduzierten mittleren freien Weglänge (λr) größere mittlere freie Weglänge (λ0) für die freien Ladungsträger im Halbleitermaterial herrscht, **dadurch** charakteriziert, daß ein Abstand (d) zwischen benachbarten Gebieten (23) mit relativ zur reduzierten mittleren freien Weglänge (λr) größerer mittlerer freier Weglänge (λ0), die durch einen diesen Abstand (d) bestimmenden Abschnitt (21) des Bereichs (2) reduzierter mittlerer freier Weglänge (λr) getrennt sind, derart vom Betrag (|E|) einer durch Anlegen einer elektrischen Spannung an Anschlusselektroden des Körpers (1) im Halbleitermaterial erzeugten elektrischen Feldstärke (E) abhängt, dass dieser Abstand (d) an einer Stelle kleineren Betrags (|E|) kleiner und an einer Stelle größeren Betrags (|E|) größer ist.

2. Körper nach Anspruch 1, wobei ein Abstand (b) zwischen benachbarten Abschnitten (21) des Bereichs (2) reduzierter mittlerer freier Weglänge (λr), die durch ein diesen Abstand (b) bestimmendes Gebiet (23) mit einer relativ zur reduzierten mittleren freien Weglänge (λr) größeren mittleren freien Weglänge (λ0) getrennt sind, derart vom Betrag (|E|) einer durch Anlegen einer elektrischen Spannung an Anschlusselektroden des Körpers im Halbleitermaterial erzeugt elektrischen Feldstärke (E) abhängt, dass dieser Abstand (b) an einer Stelle kleineren Betrags (|E|) größer und an einer Stelle größeren Betrags (|E|) kleiner ist.

3. Körper (1) nach einem der vorhergehenden Ansprüche, wobei die relativ größere mittlere freie Weglänge (λ0) eines Gebiets (23) gleich der einen mittleren freien Weglänge (λ0) des Halbleitermaterials des einen Leitungstyps (n; p) außerhalb des Bereichs (2) der reduzierten mittleren freien Weglänge (λr) ist.

4. Körper (1) nach einem der vorhergehenden Ansprüche, wobei das dotierte Halbleitermaterial unterschiedlich dotiert ist und
- zumindest einen Übergang (10) zwischen einem Leitungstyp (p; n) und einem zu diesem Leitungstyp (p; n) entgegengesetzten Leitungstyp (n; p) aufweist,
- für jeden Leitungstyp (n; p) je eine mittlere freie Weglänge (λ0) für freie Ladungsträger im Halbleitermaterial aufweist und
- für zumindest einen der beiden Leitungstypen (n; p) einen Bereich (2) aufweist, in welchem eine mittlere freie Weglänge (λr) für die freien Ladungsträger im Halbleitermaterial vorhanden ist, die relativ zur mittleren freien Weglänge (λ0) für die freien Ladungsträger des Halbleitermaterials dieses einen Leitungstyps (n; p) reduziert ist,
- wobei der Bereich (2) reduzierter mittlerer freier Weglänge (λr) Abschnitte (21) aufweist, die in Richtung (x) senkrecht zu einer Fläche (100), in der sich der Übergang (10) erstreckt, aufeinanderfolgen und zwischen denen zumindest ein Gebiet (23) vorhanden ist, in welchem eine relativ zur reduzierten mittleren freien Weglänge (λr) größere mittlere freie Weglänge (λ0) für die freien Ladungsträger herrscht, und/oder
- wobei der Bereich (2) reduzierter mittlerer freier Weglänge (λr) Abschnitte (22) aufweist, die in zumindest einer Richtung (y, z) parallel zur Fläche (100), in der sich der Übergang (10) erstreckt, aufeinanderfolgen und zwischen denen zumindest ein Gebiet (23) vorhanden ist, in welchem eine relativ zur reduzierten mittleren freien Weglänge (λr) größere mittlere freie Weglänge (λ0) für die freien Ladungsträger herrscht.

5. Körper (1) nach Anspruch 4, wobei ein Abstand (d) zwischen benachbarten Gebieten (23) mit relativ zur reduzierten mittleren freien Weglänge (λr) größerer mittlerer freier Weglänge (λ0), die durch einen diesen Abstand (d) bestimmenden Abschnitt (21) des Bereichs (2) reduzierter mittlerer freier Weglänge (λr) getrennt sind, derart vom Betrag (|E|) einer durch Anlegen einer elektrischen Sperrspannung an den Übergang (10) im Halbleitermaterial erzeugten elektrischen Feldstärke (E) abhängt, dass dieser Abstand (d) an einer Stelle kleineren Betrags (|E|) kleiner und an einer Stelle größeren Betrags (|E|) größer ist.

6. Körper (1) nach Anspruch 4 oder 5, wobei ein Abstand (b) zwischen benachbarten Abschnitten (21) des Bereichs (2) reduzierter mittlerer freier Weglänge (λr), die durch ein diesen Abstand (b) bestimmendes Gebiet (23) mit einer relativ zur reduzierten mittleren freien Weglänge (λr) größeren mittleren freien Weglänge (λ0) getrennt sind, derart vom Betrag (|E|) einer durch Anlagen einer elektrischen Sperrspannung an den Übergang (10) im Hableitermaterial erzeugt elektrischen Feldstärke (E) abhängt, dass dieser Abstand (b) an einer Stelle kleineren Betrags (|E|) größer und an einer Stelle größeren Betrags (|E|) kleiner ist.

## Claims

1. Body (1) composed of doped semiconductor material of at least one conduction type (n; p), which has a mean free path length (λ0) for free charge carriers in the semiconductor material and at least one region (2) in which a mean free path length (λr) for the free charge carriers in the semiconductor material is present that is reduced relative to the aforesaid mean free path length (λ0) of the semiconductor material for the free charge carriers,
- wherein the region (2) of reduced mean free path length (λr) has sections (21, 22) which succeed one another in at least one specific direction (x, y, z) and between which there is at least one zone (23) present in which prevails a larger mean free path length (λ0) for the free charge carriers in the semiconductor material relative to the reduced mean free path length (λr), **characterized in that** a distance (d) between adjacent zones (23) having a larger mean free path length (λ0) relative to the reduced mean free path length (λr), which are separated by a section (21) - which determines said distance (d) - of the region (2) of reduced mean free path length (λr), is dependent on the magnitude (|E|) of an electric field strength (E) generated in the semiconductor material by applying an electrical voltage to connection electrodes of the body (1) in such a way that said distance (d) is smaller at a location of smaller magnitude (|E|) and larger at a location of larger magnitude (|E|).

2. Body according to Claim 1, wherein a distance (b), between adjacent sections (21) of the region (2) of reduced mean free path length (λr), which are separated by a zone (23) - which determines said distance (b) - having a larger mean free path length (λ0) relative to the reduced mean free path length (λr), is dependent on the magnitude (|E|) of an electric field strength (E) generated in the semiconductor material by applying an electrical voltage to connection electrodes of the body in such a way that said distance (b) is larger at a location of smaller magnitude (|E|) and smaller at a location of larger magnitude (|E|).

3. Body (1) according to any of the preceding claims, wherein the relatively larger mean free path length (λ0) of a zone (23) is equal to the aforesaid mean free path length (λ0) of the semiconductor material of the one conduction type (n; p) outside the region (2) of the reduced mean free path length (λr).

4. Body (1) according to any of the preceding claims, wherein the doped semiconductor material is doped differently and
- has at least one junction (10) between one conduction type (p; n) and a conduction type (n; p) opposite to the former conduction type (p; n),
- has for each conduction type (n; p) a respective mean free path length (λ0) for free charge carriers in the semiconductor material, and
- has for at least one of the two conduction types (n; p) a region (2) in which a mean free path length (λr) for the free charge carriers in the semiconductor material is present that is reduced relative to the mean free path length (λ0) for the free charge carriers of the semiconductor material of this one conduction type (n; p),
- wherein the region (2) of reduced mean free path length (λr) has sections (21) which succeed one another in a direction (x) perpendicular to an area (100) in which the junction (10) extends and between which there is at least one zone (23) present in which prevails a larger mean free path length (λ0) for the free charge carriers relative to the reduced mean free path length (λr), and/or
- wherein the region (2) of reduced mean free path length (λr) has sections (22) which succeed one another in at least one direction (y, z) parallel to the area (100) in which the junction (10) extends and between which there is at least one zone (23) present in which prevails a larger mean free path length (λ0) for the free charge carriers relative to the reduced mean free path length (λr).

5. Body (1) according to Claim 4, wherein a distance (d) between adjacent zones (23) having a larger mean free path length (λ0) relative to the reduced mean free path length (λr), which are separated by a section (21) - which determines said distance (d) - of the region (2) of reduced mean free path length (λr), is dependent on the magnitude (|E|) of an electric field strength (E) generated in the semiconductor material by applying an electrical reverse voltage to the junction (10) in such a way that said distance (d) is smaller at a location of smaller magnitude (|E|) and larger at a location of larger magnitude (|E|).

6. Body according to Claim 4 or 5, wherein a distance (b), between adjacent sections (21) of the region (2) of reduced mean free path length (λr), which are separated by a zone (23) - which determines said distance (b) - having a larger mean free path length (λ0) relative to the reduced mean free path length (λr), is dependent on the magnitude (|E|) of an electric field strength (E) generated in the semiconductor material by applying an electrical reverse voltage to the junction (10) in such a way that said distance (b) is larger at a location of smaller magnitude (|E|) and smaller at a location of larger magnitude (|E|).

## Revendications

1. Corps (1) en matériau semi-conducteur dopé d'au moins un type (n ; p) de conductivité, qui a une longueur (λ0) de libre parcours moyen pour des porteurs de charge libres dans le matériau semi-conducteur et au moins une zone (2) dans laquelle une longueur (λr) de libre parcours moyen des porteurs de charge libres est présente dans le matériau semi-conducteur, qui est réduite par rapport à une longueur (λ0) de libre parcours moyen du matériau semi-conducteur pour les porteurs de charge libres,
- dans lequel la zone (2) de longueur (λr) de libre parcours moyen réduite a des parties (21, 22) qui se succèdent dans au moins une direction (x, y, z) déterminée et il y a entre elles au moins une région (23) dans laquelle règne une longueur (λ0) de libre parcours moyen plus grande que la longueur (λr) de libre parcours moyen réduite, **caractérisé en ce qu'**une distance (d) entre des régions (23) voisines ayant une longueur (λ0) de libre parcours moyen plus grande que la longueur (λr) de libre parcours moyen réduite, qui sont séparées par une partie (21) déterminant cette distance (d) de la zone (2) de longueur (λr) de libre parcours moyen réduite, dépend de la valeur absolue (|E|) d'une intensité (E) de champ électrique produite par application d'une tension électrique à des électrodes de borne du corps (1) dans le matériau semi-conducteur, de sorte que cette distance (d) est plus petite en un point de valeur absolue (|E|) plus petite et plus grande en un point de valeur absolue (|E|) plus grande.

2. Corps suivant la revendication 1, dans lequel une distance (b) entre des parties (21) voisines de la zone (2) de longueur (λr) de libre parcours moyen réduite, qui sont séparées par une région (23) déterminant cette distance (b) et ayant une longueur (λ0) de libre parcours moyen plus grande que la longueur (λr) de libre parcours moyen réduite, dépend de la valeur absolue (|E|) d'une intensité (E) de champ électrique produite par application d'une tension électrique aux électrodes de borne du corps, de façon que cette distance (b) soit plus grande en un point de valeur absolue (|E|) plus petite et plus petite en un point de valeur absolue (|E|) plus grande.

3. Corps (1) suivant l'une des revendications précédentes, dans lequel la longueur (λ0) de libre parcours moyen relativement plus grande d'une région (23) est égale à la longueur (λ0) de libre parcours moyen du matériau semi-conducteur d'un type (n ; p) de conductivité à l'extérieur de la zone (2) de longueur (λr) de libre parcours moyen réduite.

4. Corps (1) suivant l'une des revendications précédentes, dans lequel le matériau semi-conducteur dopé est dopé de manière différente et
- a au moins une jonction (10) entre un type (p ; n) de conductivité et un type (n ; p) de conductivité opposé à ce type (p ; n) de conductivité,
- a, pour chaque type (n ; p) de conductivité, respectivement une longueur (λ0) de libre parcours moyen des porteurs de charge libres dans le matériau conducteur et
- a, pour au moins l'un des deux types (n ; p) de conductivité, une zone (2) dans laquelle il y a une longueur (λr) de libre parcours moyen pour les porteurs de charge libres dans le matériau semi-conducteur, qui est réduite par rapport à la longueur (λ0) de libre parcours moyen des porteurs de charge libres du matériau semi-conducteur de type (n ; p) de conductivité,
- dans lequel la zone (2) de longueur (λr) de libre parcours moyen réduite a des parties (21) qui se succèdent dans la direction (x) perpendiculairement à une surface dans laquelle s'étend la jonction (10) et entre lesquelles il y a au moins une région (23) dans laquelle une longueur (λ0) de libre parcours moyen des porteurs de charge libres est plus grande que la longueur (λr) de libre parcours moyen réduite, et/ou
- dans lequel la zone (2) de longueur (λr) de libre parcours moyen réduite a des parties (22) qui se succèdent dans au moins une direction (y, z) parallèlement à la surface (100) dans laquelle s'étend la jonction (10) et entre lesquelles il y a au moins une région (23) dans laquelle règne une longueur (λ0) de libre parcours moyen des porteurs de charge plus grande que la longueur (λr) de libre parcours moyen réduite.

5. Corps (1) suivant la revendication 4, dans lequel un distance (d) entre des régions (23) voisines ayant des longueurs (λ0) de libre parcours moyen plus grandes que la longueur (λr) de libre parcours moyen réduite, qui sont séparées par une partie (21), définissant cette distance (d), de la zone (2) de longueur (λr) de libre parcours moyen réduite, dépend de la valeur absolue (|E|) d'une intensité (E) de champ électrique produite par application d'une tension électrique de blocage à la jonction (10) dans le matériau semi-conducteur, de sorte que cette distance (d) est plus petite en un point de valeur absolue (|E|) plus petite et est plus grande en un point de valeur absolue (|E|) plus grande.

6. Corps (1) suivant la revendication 4 ou 5, dans lequel une distance (b) entre des parties (21) voisines de la zone (2) de longueur (λr) de libre parcours moyen réduite, qui sont séparées par une région (23) définissant cette distance (b) et ayant une longueur (λ0) de libre parcours moyen plus grande que la longueur (λr) de libre parcours moyen réduite, dépend de la valeur absolue (|E|) d'une intensité (E) de champ électrique produite par application d'une tension de blocage électrique à la jonction (10) dans le matériau semi-conducteur, de sorte que cette distance (b) est plus grande en un point de valeur absolue (|E|) plus petite et plus petite en un point de valeur absolue (|E|) plus grande.
